# EUROPÄISCHE PATENTSCHRIFT

(11) **EP 1 571 674 B1**
(45) Veröffentlichungstag und Bekanntmachung des Hinweises auf die Patenterteilung: **02.07.2008**
(21) Anmeldenummer: 05004953.5
(22) Anmeldetag: 07.03.2005
(51) Int. Cl.: G11C 16/04, G11C 16/26

(54) **Verfahren zum Betreiben einer elektrischen beschreib- und löschbaren Speicherzelle und eine Speichereinrichtung zum elektrischen Speichern**
Method for operating an electrically erasable and programmable memory cell and corresponding memory device
Procédé de commande d'une cellule de mémoire effaçable et programmable électriquement et dispositif de mémoire correspondant

(30) Priorität: 05.03.2004 DE 102004010840
(43) Veröffentlichungstag der Anmeldung: 07.09.2005
(73) Patentinhaber: Qimonda AG, 81739 München (DE)
(72) Erfinder: Deppe, Joachim, 01099 Dresden (DE); Isler, Mark, 01109 Dresden (DE); Ludwig, Christoph, 01465 Langenbrück (DE); Sachse, Jens-Uwe, 01217 Dresden (DE); Schley, Jan-Malte, 01277 Dresden (DE); Mikalo, Ricardo Pablo, 15926 Waltersdorf (DE)
(74) Vertreter: Epping - Hermann - Fischer

(56) Entgegenhaltungen:
- WO-A-99/60631
- JP-A- 11 317 087
- US-A1- 2004 042 270

## Beschreibung

Die Erfindung betrifft ein Verfahren zum Betreiben einer elektrischen beschreib- und löschbaren Speicherzelle und eine Speichereinrichtung zum elektrischen Beschreiben und Löschen.

Zu den elektrisch beschreib- und löschbaren nicht flüchtigen Speicherzellen, die insbesondere in einer virtuell-ground-NOR-Architektur eingesetzt werden können, gehören auch sogenannte Charge-Trapping-Speicherzellen, bei denen zwischen dem Kanalbereich und/oder dem Source-/Drain-Bereich und der Gate-Elektrode ein Teil des Gate-Dielektrikums eine nicht leitende Speicherschicht zwischen Begrenzungsschichten für den Einfang von Ladungsträgern und damit zur Veränderung des Programmierzustandes der Speicherzelle vorhanden ist. Das sind beispielsweise SONOS-Speicherzellen (semiconductor-oxydnitrid-oxyd-semiconductor). Derartige Speicherzellen sind z. B. in der US 5,768,192, der US 6,011,725 und der WO 99/60631 beschrieben. Bei diesen Speicherzellen ist jede Begrenzungsschicht ein Oxyd und die Speicherschicht ein Nitrid des Halbleitermaterials, üblicherweise Silizium. Charge-Trapping-Speicherzellen werden vorzugsweise durch Channel-Hot-Electrons (CHE) programmiert und können mit Hot-Holes aus dem Kanalbereich oder durch Fowler-Nordheim-Tunneln gelöscht werden. Eine für eine spezielle Betriebsweise mit einer zum Programmiervorgang gegensinnig angelegten Lesespannung (reverse-read) vorgesehene SONOS-Speicherzelle mit einer an diese Betriebsweise angepasste Dicke der Begrenzungsschichten wird üblicherweise als NROM-Speicherzelle bezeichnet. Weitere Ausführungen hierzu finden sich in Boaz Eitan et al.: "NROM: A Novel Localized Trapping, 2 Bit nonvolatile memory cell" in IEEE Electron Device Letters 21,543-545 (2000)). Die Speicherschicht einer Charge-Trapping-Speicherzelle befindet sich zwischen Begrenzungsschicht aus einem Material einer höheren Energiebandlücke als der Energiebandlücke der Speicherschicht, so dass die Ladungsträger, die in der Speicherschicht eingefangen werden, dort lokalisiert bleiben. Als Material für die Speicherschicht kommt vorzugsweise ein Nitrid in Frage; als umgebendes Material ist vorrangig ein Oxyd geeignet. Als Beispiel einer solchen Oxyd-Nitrid-Oxyd-(ONO) Speicherschichtfolge im Materialsystem von Silizium ist die Speicherschicht Siliziumnitrid mit einer Energiebandlücke von etwa 5 eV vorgesehen. Die umgebenden Begrenzungsschichten sind Siliziumoxyd mit einer Energiebandlücke von etwa 9 eV. Die Speicherschicht kann ein anderes Material sein, dessen Energiebandlücke kleiner als die Energiebandlücke der Begrenzungsschichten ist, wobei die Differenz der Energiebandlücken für einen guten elektrischen Einschluss der Ladungsträger möglichst groß sein soll. In Verbindung mit Siliziumoxyd als Begrenzungsschicht kann z. B. Tantaloxyd, Hafniumsilicat, Titanoxyd (im Fall stöchiometrischer Zusammensetzung TiO₂), Zirkonoxyd (im Fall stöchiometrischer Zusammensetzung ZrO₂), Aluminiumoxyd (im Fall stöchiometrischer Zusammensetzung Al₂O₃) oder intrinsisch leitendes (undotiertes) Silizium als Material der Speicherschicht eingesetzt werden. Die Programmierung einer derartigen 2-Bit-NROM-Speicherzell, wie sie z. B. in der WO 98/03977 beschrieben ist, erfolgt in der Art, dass mittels einer Gate-Spannung und einer Drain-Source-Spannung im Kanalbereich der Speicherzelle ein vertikales und ein laterales elektrisches Feld erzeugt wird, das die Elektronen entlang der Kanallänge beschleunigt. Einige Elektronen werden dabei so beschleunigt, dass sie in der Nähe des Drain-Bereichs, wo das elektrische Feld am stärksten ist, über die Potentialbarriere springen und zur Nitridschicht gelangen. Auf diese Weise ändert sich die Einsatzspannung des Kanalbereiches, was durch Anlegen einer Lesespannung in umgekehrter Richtung feststellbar ist. Das zweite Bit in dieser Speicherzelle wird dadurch programmiert, dass für das Beschreiben der Speicherzelle und damit das signifikante Einstellen von Ladungen in die Charge-Trapping-Schicht , Drain und Source gegenüber dem vorhergehenden beschriebenen Programmiervorgang vertauscht werden. Auf diese Weise kann in einer nicht flüchtigen Speicherzelle, wie beispielsweise einer NROM-Zelle, eine Information von 2-Bit abgespeichert werden.

Nachteil dieser bekannten Vorgehensweise ist es, dass beim Einbringen von Ladungen in die Charge-Trapping-Schicht auf der einen Seite einer derartigen Zelle Rückwirkungen auf die Einsatzspannung der jeweils andere Seite der Speicherzelle auftreten. Es kommt somit zu einem sogenannten Nebensprechen. Das Nebensprechen nimmt mit steigender Differenz der Einsatzspannungen der beiden Seiten einer Zelle stark zu.

Dieses Nebensprechen kann sich wie folgt auswirken. Zum Lesen einer NROM-Speicherzelle wird eine bestimmte Gate-Spannung und eine Drain/Source-Spannung angelegt. Drain und Source werden dabei so definiert, dass die gewünschte Seite der Speicherzelle gelesen wird. Ist keine Ladung in der Nitridschicht gespeichert, fließt bei einer vorgegebenen Gatespannung ein charakteristischer Drainstrom. Ist eine bestimmte Ladung in der Nitridschicht gespeichert, so behindert diese das Ausbilden eines Kanals zwischen Source und Drain und es fließt bei der gleichen Gatespannung kein Drainstrom oder er ist zumindest signifikant geringer. Dieses Verhalten ist in einer üblichen Transferkennlinie darstellbar. Das Programmieren einer Seite der NROM-Zelle kann dazuführen, dass sich die Transferkennlinie der anderen Seite der NROM-Zelle verändert, so dass beispielsweise ein Drainstrom bei der vorgegebenen Gatespannung fließt, obwohl zuvor keine Ladung in der Nitridschicht gespeichert wurde.

Ein Verfahren zur Verminderung dieses Nachteils ist aus der US 2004/042270 bekannt.

Mit der Weiterentwicklung der Technologie sinkt die effektive Kanallänge und somit der physikalische Abstand zwischen den Ladungen der beiden Seiten einer Zelle. Dies führt zu stärkerem Nebensprechen. Es ist damit zu rechnen, dass es in Zukunft in verstärktem Maße zu Fehlern kommt, die durch Nebensprechen zustande gekommen sind.

Daher liegt der Erfindung die Aufgabe zugrunde, eine Speichereinrichtung zum elektrischen Beschreiben und Löschen von Speicherzellen vorzusehen und ein Verfahren zum Betreiben einer solchen Speichereinrichtung, bei der das Auftreten der o. g. Fehler vermieden ist.

Diese Aufgabe wird erfindungsgemäß mit den in den unabhängigen Patentansprüchen angegebenen Maßnahmen gelöst. Die Auswirkung des Nebensprechens wird bei der Wahl der Einsatzspannung als Betriebsparameter minimiert, indem es nie zu großen Einsatzspannungsdifferenzen zwischen den beiden Seiten einer Zelle kommt. Dies wird insbesondere dadurch realisiert, dass zumindest ein Teil der Information, nämlich ein Bit, als Differenz der Einsatzspannung des Kanalbereichs abgespeichert wird, die wiederum nicht durch Übersprechen beeinflusst wird, ist das Auftreten von Fehlern durch Übersprechen in der Speicherzelle vermieden.

Weiterhin ist durch das Programmieren mittels Einsatzspannungsdifferenz der Gebrauch einer Referenzzelle vermieden. Wird allein die in der Betriebsparameterdifferenz liegende Information verwendet, so ist eine 1 Bit-Speicherzelle erzielbar, die eine sehr große Zuverlässigkeit aufweist.

Weitere vorteilhafte Ausgestaltungen sind in den untergeordneten Patentansprüchen angegeben. Insbesondere dadurch, dass neben der Einsatzspannungsdifferenz ein Spannungsbereich festgelegt ist, innerhalb dessen die Einsatzspannung vom Absolutbetrag liegt, ist mit dieser Maßnahme erzielbar, dass durch das Festlegen von zwei und mehr Spannungsbereichen, in einer Speicherzelle mehr als 2 Bit abspeicherbar sind.

Nachfolgend wird die Erfindung unter Bezugnahme auf die Zeichnungen anhand von Ausführungsbeispielen erläutert.

### Es zeigen:

- Figur 1: ein erstes Beispiel einer NROM-Speicherzelle,
- Figur 2: ein zweites Ausführungsbeispiel einer NROM-Speicherzelle,
- Figur 3: ein übliches Speicherzellenfeld für NROM-Zellen,
- Figur 4: ein Ausführungsbeispiel des erfindungsgemäßen Abspeicherns von vier Zuständen in einer nicht flüchtigen Speicherzelle und
- Figur 5: die bisher übliche Vorgehensweise des Abspeicherns von vier Zuständen in einer üblichen NROM-Speicherzelle.

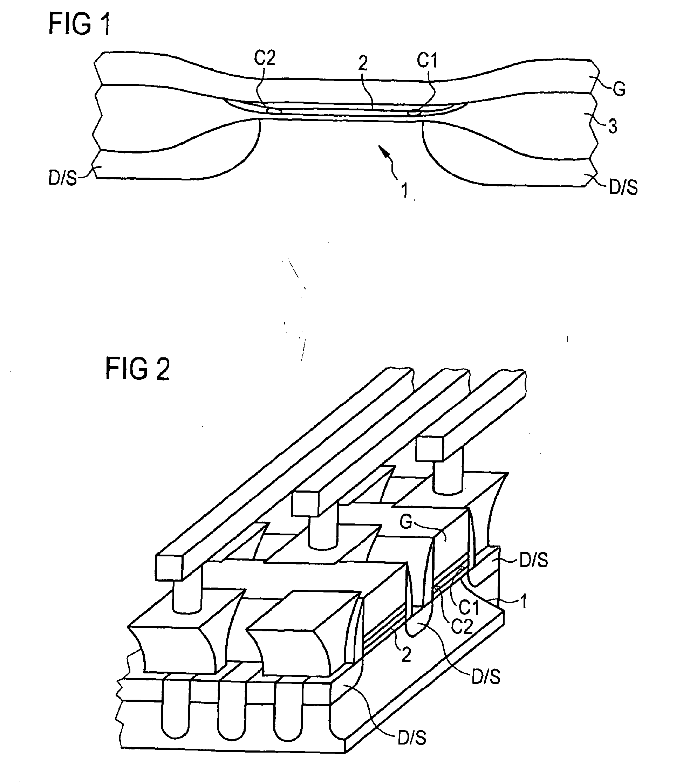

Figur 1 zeigt den Prinzipaufbau einer üblichen NROM-Speicherzelle. Auf einem Substrat 1 sind voneinander beabstandete Drain-/Source-Gebiete D/S angeordnet, zwischen denen eine Gate-Struktur 2 ausgebildet ist. Diese Gate-Struktur 2 besteht aus drei Schichten, in der Schichtabfolge einer Oxidschicht, einer Nitridschicht und einer Oxidschicht. Die Gate-Struktur 2 wird vervollständigt durch einen Gate-Kontakt G, über den die Gate-Spannung über der Gate-Struktur 2 angelegt wird, abgedeckt. Der Gate-Kontakt G ist dabei über eine Isolation 3, die im vorliegenden Ausführungsbeispiel durch ein Oxid gebildet ist, von den Drain-/Source-Gebieten D/S getrennt. Die NROM-Speicherzelle entspricht somit der Struktur eines MOS-Transistors, der im Weiteren als Zelltransistor bezeichnet ist. So wie in der Beschreibungsanleitung bereits beschrieben ist, wird je nachdem, welches der beiden Gebiete D/S jeweils Drain oder Source ist, im Gebiet C2 oder im Gebiet C1 eine Ladung in der Gate-Struktur 2 gespeichert oder gelöscht. Die Speicherung der Ladung erfolgt dabei in der Nitrid-Schicht mittels so genannter "hot elekton injection". Das Löschen der Ladung erfolgt mittels so genanntem "Fowler-Notheim tunneling". Dabei erfolgt das Programmieren indem dem jeweiligen Draingebiet räumlich benachbarten Gebiet C1 oder C2. Durch das dem Programmieren bzw. Schreiben umgekehrten Leserichtung wird die programmierte Information detektiert. Das Detektieren der gespeicherten Information erfolgt dabei durch Ermittlung der Einsatzspannung oder Schwellspannung des Zelltransistors. Beim Lesen ist die gespeicherte Ladung in der Nähe des Source-Gebietes für die Einsatzspannung relevant.

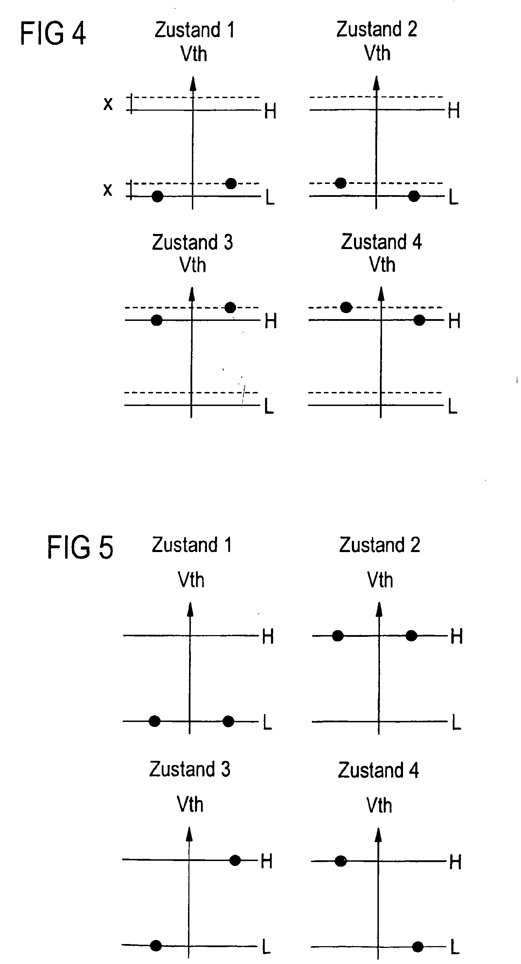

In Figur 4 sind Programmierzustände gemäß der erfindungsgemäßen Zustandsprogrammierung dargestellt. Dabei ist mit den ausgefüllten Kreisen jeweils der Wert der Schwellspannung für die linke und rechte Seite einer Speicherzelle dargestellt. Beim Zustand 1 liegt dabei die Schwellspannung im linken Bereich unterhalb der Schwellspannung im rechten Bereich, wobei folglich der Zustand durch die von links nach rechts bestimmte Schwellspannungsdifferenz auf dem Schwellspannungsniveau L bestimmt ist. Dies bedeutet, dass eine Speicherzelle, wie sie beispielsweise in Figur 1 dargestellt ist, einmal links und einmal rechts durch vertauschen von Drain und Source auf den "L"-Pegel programmiert wird, wobei die Programmierung so erfolgt, dass die Schwellspannung im rechten Teil der Zelle höher ist als im linken Teil und sich eine Schwellspannungsdifferenz innerhalb eines Bereiches ergibt.

Der Zustand 2 ergibt sich nunmehr in analoger Form, wobei die Schwellspannung im linken Teil höher ist als im rechten Teil. Die Differenz ist dabei absolut betrachtet zwischen dem Zustand 1 und dem Zustand 2 die gleiche, allein das mathematische Vorzeichen der Differenz der beiden Schwellspannungen ist für die Auswertung des gespeicherten logischen Zustands ausschlaggebend.

Zustand 3 und Zustand 4 in Figur 4 ergeben sich in vergleichbarer Weise wie Zustand 1 und Zustand 2, wobei hier die dargestellten Schwellspannungen sich im Bereich des "H"-Pegels befinden. Auch hier ist für den Unterschied zwischen dem Zustand 3 und dem Zustand 4 das Vorzeichen der jeweiligen Differenz maßgeblich. Die übliche Programmierung, wie sie in Figur 5 dargestellt ist, erfolgt in der Form, dass beispielsweise der Zustand 1 dadurch definiert ist, dass die Schwellspannung im linken Teil der Zelle und im rechten Teil der Zelle jeweils auf dem "L"-Pegel liegt und dem gegenüber der Zustand 2 dadurch definiert ist, dass im linken Teil und im rechten Teil der Zelle die Schwellspannung jeweils auf dem "H"-Pegel liegt. Des weiteren ist der Zustand 3 dadurch definiert, dass die Spannung im linken Teil der Zelle auf dem "L"-Pegel und im rechten Teil auf dem "H"-Pegel liegt, wobei der Zustand 4 dadurch definiert ist, dass die Schwellspannung im linken Teil der Zelle auf dem "H"-Pegel und im rechten Teil auf dem "L"-Pegel liegt.

Als ein Beispiel kann die Differenz der Schwellspannungen zwischen dem "L"-Pegel und dem "H"-Pegel mit ca.1,5 V und die Schwellspannungspegeldifferenz innerhalb des "L"-Pegels bzw. des "H"-Pegels, d.h.zwischen den Zuständen 1 und 2 bzw. 3 und 4 mit ca. 300 mV angegeben werden. Es sind jedoch auch andere Differenzen realisierbar.

Im zuvor beschriebenen Ausführungsbeispiel sind vier Zustände, die auf zwei Pegel verteilt sind, beschrieben worden. Es handelt sich folglich um eine 2-Bit-Speicherzelle. Werden zusätzlich zum "H"-Pegel und dem "L"-Pegel ein oder mehrere weitere Pegel definiert, so können in analoger Weise zusätzliche Bits in einer Speicherzelle gespeichert werden.

Der Vorteil der Zustandsdefinition, gemäß Figur 4 ist darin zu sehen, dass jeweils die Differenz zwischen dem linken Teil der Zelle und dem rechten Teil der Zelle programmiert wird, wobei beide Schwellspannungspegel innerhalb des gleichen Bereichs liegen. Es treten nie größere Einsatzspannungsdifferenzen zwischen den beiden Seiten einer Zelle auf.

Bei der Programmierung von Zustand 3 des bekannten Verfahren wird die Einsatzspannung der rechten Seite deutlich über jene der linken Seite angehoben. Nebensprechen konnte dabei dafür sorgen, dass der linke Teil der Zelle mit angehoben wird.

Gemäß Figur 2 ist in räumlicher Darstellung eine andere Ausgestaltung einer NROM-Speicherzelle dargestellt, wobei der wesentliche Unterschied allein in der Kontaktierung des Gatekontaktes G und der Drain-/Source-Gebiete D/S gegenüber dem in Figur 1 dargestellten Ausführungsbeispiel zu sehen ist. Auch hier sind innerhalb der Gate-Struktur zwei Ladungsbereiche C1 und C2 vorgesehen, in denen Ladung eingebettet oder gelöscht wird. Die erfindungsgemäße Programmierung lässt sich für beide dargestellte Ausführungsbeispiele von NROM-Speicherzellen und darüber hinaus für weitere Speicherzellen anwenden, die im Gatebereich zumindest zwei lokale Speicherbereiche aufweist, die einen Betriebsparameter wie die Einsatzspannung beeinflussen.

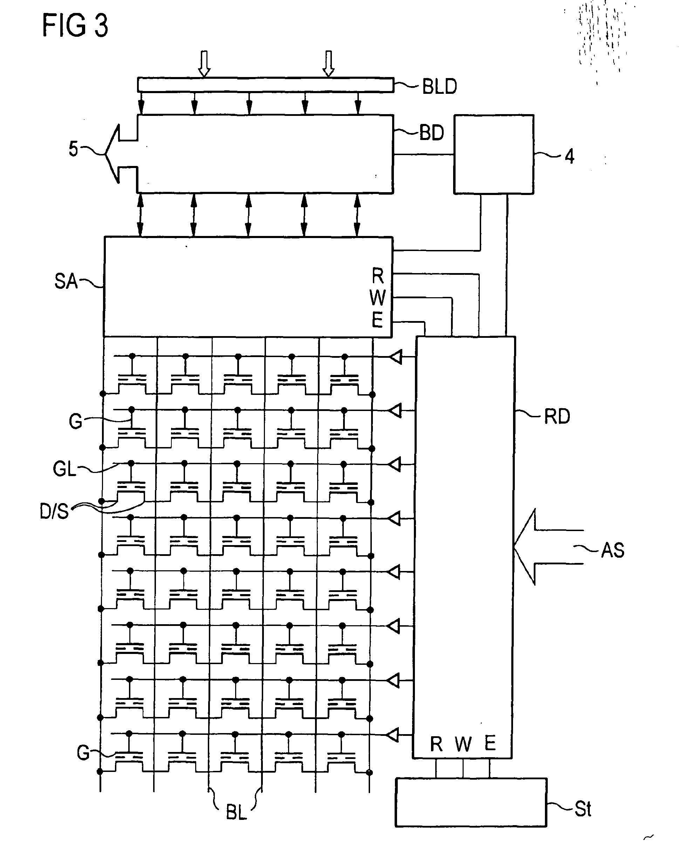

Gemäß Figur 3 ist eine übliche Speicherzellenanordnung für nicht flüchtige Speicher dargestellt, die für das erfindungsgemäße Verfahren eingesetzt werden kann. Es sind mehrere Reihen von Speicherzellen dargestellt, wobei in jeder Reihe ein Drain-/Source-Anschluß D/S einer Zelle mit einem Drain-/Source-Anschluß D/S der Nachbarzelle verbunden ist. Die Drain-/Source-Anschlüsse sind mit Bitleitungen BL verbunden und werden über einen so genannten "sense amplifier" SA angesteuert. Die Gate-Anschlüsse G der einzelnen Speicherzellen innerhalb einer Reihe werden von einem Reihendecodierer RD über jeweilige Gate-Leitungen GL angesteuert. Die Adressierung der Speicherzellen erfolgt über den Reihendecodierer RD und über einen Bitleitungsdecodierer BDL. Zwischen dem Bitleitungsdecodierer BDL und dem "sense amplifier" SA ist ein Multi-Bit-Decodierer BD angeordnet, der dafür sorgt, dass die jeweilige Schwellspannungsdifferenz auf dem jeweiligen gewünschten Pegel, wie zuvor beschrieben, bei einem Programmiervorgang in den Speicherzellen eingestellt wird, bzw. der durch ein Vorwärts- und Rückwärtslesen der jeweiligen Speicherzellen aus der Schwellspannungsdifferenz den auf den jeweiligen Pegel programmierten Zustand ermittelt und an den Datenausgang 5 abgibt. Der Multi-Bit-Decodierer BD umfaßt folglich eine Einrichtung zum Erzeugen einer Schwellspannungsdifferenz in den einzelnen Speicherzellen, sowie eine Einrichtung zum Detektieren einer solchen Schwellspannungsdifferenz. Das Zusammenwirken zwischen dem Bitdecodierer, dem "Sense Amplifier" und dem Reihendecodierer RD erfolgt wird über eine Taktsteuerung 4 gesteuert. Schließlich ist eine Zustandssteuerung ST vorgesehen, die vorgibt, ob ein Lesevorgang R, ein Schreibvorgang W oder ein Löschvorgang E vorgesehen ist.

Das vorangehende Ausführungsbeispiel bezieht sich auf die NROM-Zelle. Die Erfindung ist jedoch nicht darauf beschränkt sondern auf jede Speicherzelle anwendbar, die zumindest zwei getrennte Speicherbereiche aufweist, die einen Einfluß auf einen Betriebsparameter haben.

### Bezugszeichenliste

- 1: Substrat
- 2: Gate-Struktur
- 3: Isolation
- 4: Taktsteuerung
- 5: Datenausgang
- G: Gate-Anschluss
- GL: Gate-Leitung
- D/S: Drain-/Source-Gebiet
- BL: Bitleitung
- C1: Ladungsbereich 1
- C2: Ladungsbereich 2
- AS: Adresssteuerung
- RD: Reihendecodierer
- ST: Zustandssteuerung
- SA: Schreibverstärker
- BD: Multi-Bit-Decodierer
- BDL: Bitleitungsdecodierer

## Patentansprüche

1. Verfahren zum Betreiben einer elektrisch beschreib- und löschbaren Speicherzelle, die einen Kanalbereich (2) aufweist, der in einer ersten und einer zweiten Richtung betreibbar ist und die Speicherzelle durch zumindest einen Betriebsparameter charakterisiert ist, wobei eine Information als Differenz des Betriebsparameters zwischen dem Betrieb des Kanalbereichs in der ersten Richtung und dem Betrieb des Kanalbereichs in der zweiten Richtung gespeichert wird.

2. Verfahren nach Anspruch 1, wobei zwei Informationen **dadurch** unterschieden werden, in welcher Richtung des Betriebs des Kanalbereichs der Betriebsparameter einen höheren Wert aufweist, wobei die Differenz des Betriebsparameters betragsgleich ist.

3. Verfahren nach Anspruch 2, bei dem der Betriebsparameter die Einsatzspannung (VT) eines Speicherzellentransistors (G, D/S)ist.

4. Verfahren nach Anspruch 3, bei dem die beiden Einsatzspannungen (VT) innerhalb eines vorbestimmten Spannungsbereichs festgelegt sind.

5. Verfahren nach Anspruch 4, wobei weitere Informationen innerhalb weiterer vorbestimmter Spannungsbereiche festgelegt werden.

6. Speichereinrichtung für elektrisch les- und löschbares Speichern von Informationen,
mit einem Speicherzellenfeld mit zumindest einer Speicherzelle, die einen Kanalbereich (2) zwischen einem Drainbereich und einem Sourcebereich aufweist, der Kanalbereich bidirektional betreibbar ist und die ein Speichergebiet (C1, C2) aufweist, das derart einstellbar ist, dass ein Betriebsparameter der Speicherzelle bei Betrieb des Kanalbereichs in einer ersten Richtung gegenüber dem Betrieb des Kanalbereichs in der zweiten Richtung verschieden ist, wobei
eine Lesevorrichtung (10, 12)vorgesehen ist, die die Differenz des Betriebsparameters ermittelt und einen Programmierzustand zuordnet.

7. Speichereinrichtung nach Anspruch 6, **gekennzeichnet durch** eine Schreibvorrichtung, die das Speichergebiet derart einstellt, dass eine zu speichernde Information einer Einsatzspannungsdifferenz des Kanalbereichs entspricht.

8. Speichereinrichtung nach Anspruch 7, **dadurch gekennzeichnet, dass** die zu speichernde Information ein Bit umfasst.

9. Speichereinrichtung nach Anspruch 8, **dadurch gekennzeichnet, dass** die Speicherzelle ein NROM-Speicherzellenelement ist.

10. Speichereinrichtung nach Anspruch 8, **dadurch gekennzeichnet, dass** das Speichergebiet der Speicherzelle lokale Ladungsspeicher aufweist.

## Claims

1. Method for operating an electrically writable and erasable memory cell comprising a channel region (2), wherein the channel region (2) can be operated in a first direction and in a second direction, and the memory cell is **characterized by** at least one operating parameter, wherein an item of information being stored as the difference in the operating parameter between operation of the channel region in the first direction and operation of the channel region in the second direction.

2. Method according to Claim 1, wherein two items of information being distinguished by the direction of operation of the channel region in which the operating parameter has a higher value and wherein the magnitude of the difference in the operating parameter being the same.

3. Method according to Claim 2, in which the operating parameter is the threshold voltage (VT) of a memory cell transistor (G, D/S).

4. Method according to Claim 3, in which the two threshold voltages (VT) are defined within a predetermined voltage range.

5. Method according to Claim 4, wherein further items of information being defined within further predetermined voltage ranges.

6. Memory device, configured to an electrically readable and erasable storage of information items,
said device comprising a memory cell array with at least one memory cell comprising a channel region (2) between a drain region and a source region, the channel region being able to be operated in a bidirectional manner, and the memory cell further comprising a memory area (C1, C2) configured to be set in such a manner that an operating parameter of the memory cell is different when the channel region is operated in a first direction to when the channel region is operated in the second direction, wherein
provision being made of a reading apparatus (10, 12), wherein the reading apparatus determines the difference in the operating parameter and assigns a programming state.

7. Memory device according to Claim 6, **characterized in that** a writing apparatus configured to set the memory area therewith that an item of information to be stored corresponds to a threshold voltage difference of the channel region.

8. Memory device according to Claim 7, **characterized in that** the item of information to be stored comprises one bit.

9. Memory device according to Claim 8, **characterized in that** the memory cell is an NROM memory cell element.

10. Memory device according to Claim 8, **characterized in that** the memory area of the memory cell comprises local charge stores.

## Revendications

1. Procédé pour faire fonctionner une cellule de mémoire, dans laquelle on peut écrire et effacer électriquement et qui a une zone (2) de canal qui peut fonctionner dans un premier et dans un deuxième sens et la cellule de mémoire étant **caractérisée par** au moins un paramètre de fonctionnement, une information étant mémorisée sous la forme d'une différence du paramètre de fonctionnement entre le fonctionnement de la zone de canal dans le premier sens et le fonctionnement de la zone de canal dans le deuxième sens.

2. Procédé suivant la revendication 1, dans lequel on fait la différence entre deux informations par le sens du fonctionnement de la zone de canal dans lequel le paramètre de fonctionnement a une valeur plus grande, la différence du paramètre de fonctionnement étant la même en valeur absolue.

3. Procédé suivant la revendication 2, dans lequel le paramètre de fonctionnement est la tension (VT) de coupure d'un transistor (G, D/S) de cellules de mémoire.

4. Procédé suivant la revendication 3, dans lequel les deux tensions (VT) de coupure sont fixées dans un intervalle de tension déterminé à l'avance.

5. Procédé suivant la revendication 4, dans lequel d'autres informations sont fixées à l'intérieur d'autres intervalles de tension déterminés à l'avance.

6. Dispositif de mémoire pour la mémorisation d'informations pouvant être lues et effacées électriquement, comprenant un champ de cellules de mémoire ayant au moins une cellule de mémoire, qui a une zone (2) de canal entre une zone de drain et une zone de source, la zone de canal pouvant fonctionner de façon bidirectionnelle et ayant une région (C1, C2) de mémoire qui est réglée de façon à ce qu'un paramètre de fonctionnement de la cellule de mémoire soit différent lorsque la zone de canal fonctionne dans un premier sens par rapport au fonctionnement de la zone de canal dans le deuxième sens,dans lequel
il est prévu un dispositif (10, 12) de lecture, qui détermine la différence du paramètre de fonctionnement et associe un état de programmation.

7. Dispositif de mémoire suivant la revendication 6, **caractérisé par** un dispositif d'écriture, qui règle la région de mémoire de façon à ce qu'une information à mémoriser corresponde à une différence de tension de coupure de la zone de canal.

8. Dispositif de mémoire suivant la revendication 7, **caractérisé en ce que** l'information à mémoriser comprend un bit.

9. Dispositif de mémoire suivant la revendication 8, **caractérisé en ce que** la cellule de mémoire est un élément de cellule de mémoire NROM.

10. Dispositif de mémoire suivant la revendication 8, **caractérisé en ce que** la région de mémoire de la cellule de mémoire a des accumulateurs de charge locaux.
